# FASCICULE DE BREVET EUROPEEN

(11) **EP 4 347 405 B1**
(45) Date de publication et mention de la délivrance du brevet: **05.03.2025**
(21) Numéro de dépôt: 22730917.6
(22) Date de dépôt: 31.05.2022
(51) Int. Cl.: B64G 1/50, B64G 1/22, B64G 1/64

(54) **STRUCTURE RÉGULATRICE DE CHALEUR PAR CALODUC OPTIMISÉE POUR PANNEAUX SUPPORTS D'ÉQUIPEMENTS ÉLECTRONIQUES**
OPTIMIERTE STRUKTUR ZUR WÄRMEREGULIERUNG ÜBER WÄRMEROHR FÜR TRÄGERPLATTEN ELEKTRONISCHER GERÄTE
OPTIMISED STRUCTURE FOR REGULATING HEAT VIA HEAT PIPE FOR ELECTRONIC EQUIPMENT SUPPORT PANELS

(30) Priorité: 31.05.2021 BE 202105435
(43) Date de publication de la demande: 10.04.2024
(73) Titulaire: Sonaca S.A., 6041 Gosselies (BE)
(72) Inventeur: MABED, Barbara, 6041 GOSSELIES (BE); BEKEMANS, Marc, 6032 CHARLEROI (BE)
(74) Mandataire: Brevalex
(86) Numéro de dépôt international: PCT/EP2022/064768
(87) Numéro de publication internationale: WO 2022/253837

(56) Documents cités:
- FR-A1- 2 951 695
- JP-A- S6 383 586
- US-A- 4 388 964
- US-A1- 2003 196 778
- US-B2- 9 238 513

## Description

### DOMAINE TECHNIQUE

La présente invention s'inscrit dans le domaine des engins spatiaux, et se rapporte plus spécifiquement à la problématique de gestion de la chaleur émise par des équipements électroniques embarqués dans ce type d'engins.

### ÉTAT DE LA TECHNIQUE ANTÉRIEURE

Les engins spatiaux, tels que les satellites de télécommunication ou les sondes, comportent des équipements électroniques de haute puissance disposés au sein d'un caisson hermétique délimité par des panneaux structuraux. Ces équipements sont portés par des panneaux structuraux qui se présentent usuellement sous la forme de panneaux sandwich comprenant deux structures de surface, ou « peaux », enserrant une âme, par exemple en nid-d'abeilles. Ce choix de construction de panneaux est largement adopté par les constructeurs en ce qu'il combine une forte rigidité pour une masse minimale.

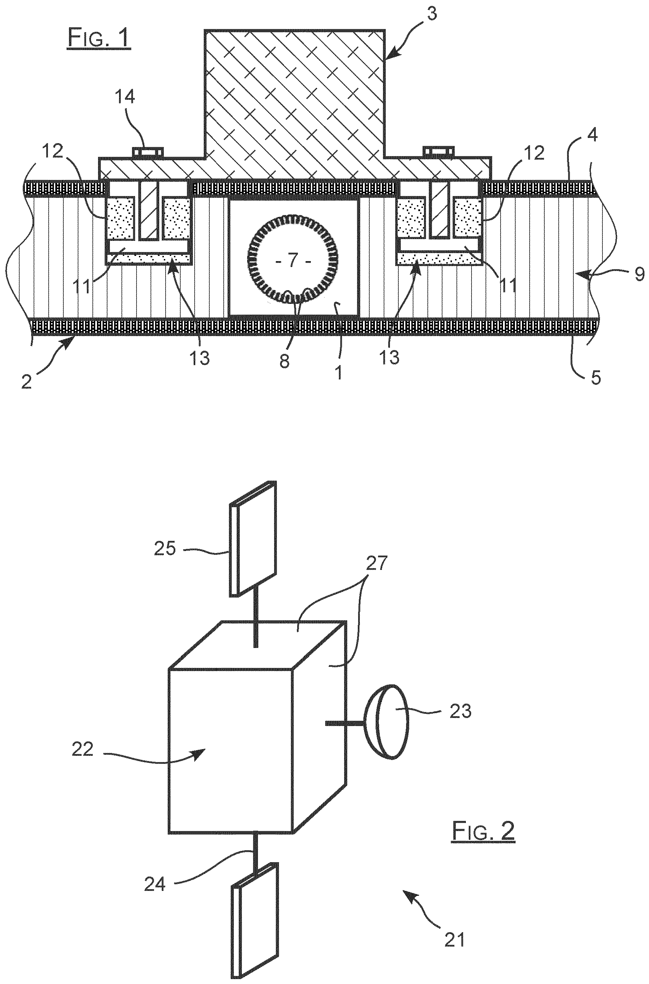

Les équipements électroniques embarqués génèrent des quantités importantes de chaleur. Cette chaleur doit être dissipée vers l'extérieur du caisson pour assurer une température ambiante stable et admissible au fonctionnement continu de ces équipements électroniques. L'espace extra-atmosphérique environnant le satellite durant sa vie en fonctionnement étant vide d'air, autrement dit un refroidissement par ventilation demeurant impossible, il s'agit de dissiper cette chaleur émise. A cet égard, la solution majoritairement retenue consiste à équiper les panneaux structuraux d'échangeurs passifs de température de type caloduc, dont le fonctionnement repose sur le principe de transition de phase d'un matériau pour absorber/céder de l'énergie, selon le principe connu d'évaporation-condensation. Dans une telle application, un caloduc, repéré par 1 sur la figure 1, se présente classiquement sous la forme d'une barre qui est introduite au cœur d'un panneau 2, au droit de l'équipement 3 et en contact thermique direct avec les deux peaux 4, 5. Il délimite en son sein un tube creux 7, scellé de manière étanche en ses deux extrémités, qui encapsule un fluide caloporteur diphasique. Le fluide caloporteur se vaporise à proximité de l'équipement 3 en absorbant la chaleur emmagasinée par la peau 4 (source chaude) sur laquelle ce dernier est monté, dite peau intérieure. Le fluide se condense par la suite à distance de l'équipement 3 pour retourner à l'état liquide en cédant par diffusion l'énergie thermique à la peau extérieure 5 (source froide) qui baigne dans l'espace extra-atmosphérique froid. En pratique, étant donné que la gravité est essentiellement inexistante durant la vie en fonctionnement de l'engin spatial, des cannelures 8 longitudinales sont prévues pour dépasser de la surface interne du tube 7 radialement vers l'intérieur, et ainsi permettre la circulation des phases liquide et gazeuse dans un sens ou l'autre par capillarité.

L'une des difficultés associées à l'utilisation de panneau sandwich réside dans la fixation des équipements 3 au droit du caloduc 1. En effet, l'âme 9 en nid-d'abeilles et les peaux 4, 5, en raison de leur faible épaisseur, ont des propriétés mécaniques insuffisantes pour supporter une charge concentrée en un point comme celle occasionnée par l'introduction directe d'un élément de visserie. Pour garantir une bonne tenue de l'assemblage, des inserts 11 ont donc été développés pour réaliser l'interfaçage entre le panneau sandwich et les moyens de fixation adoptés, et ainsi répartir les efforts de liaison locaux sur une plus grande surface. Ces inserts 11 sont placés dans des logements 12 formés par usinage/perçage au travers du panneau 2, aux points précis de fixation de l'équipement. L'insert 11 est collé « à froid » ou à faible température par introduction d'une colle 13 de type « potting » injectée entre l'insert 11 et le nid-d'abeilles 9, avant de recevoir un moyen de fixation comme une vis repérée par 14.

En pratique, recourir à des inserts requiert le respect de tolérances restreintes de localisation, d'inclinaison et d'affleurement, lesquelles sont souvent définies tardivement lors de la conception du produit en ce qu'il s'agit de connaitre précisément l'emplacement de destination des équipements électroniques futurs, et, par voie de conséquence, l'emplacement des caloducs. De plus, le contrôle visuel n'est pas toujours rendu possible, notamment dans le cas d'un insert situé en milieu de panneau, ce qui nécessite de prévoir des éprouvettes de contrôle ou l'application directe d'une charge sur l'insert pour vérifier sa bonne tenue mécanique. Enfin, il est à noter qu'un changement inopiné de localisation d'un équipement a postériori engendrera un nouveau perçage, risquant de pénaliser la résistance mécanique globale du panneau, voire la fabrication d'un nouveau panneau si l'équipement est trop éloigné d'un caloduc.

Ainsi, l'utilisation d'inserts génère un certain nombre de contraintes d'assemblage tout en étant assujettie à des retards et coûts supplémentaires de production.

Le but de l'invention est donc de proposer une solution d'intégration des équipements électroniques qui à la fois est compatible avec l'utilisation de panneaux sandwich dissipatifs de chaleur, et qui résout au moins partiellement les inconvénients identifiés de l'état de la technique. Le document US9238513 B2 divulgue un ensemble comportant un panneau et un profilé avec un fluide caloporteur selon l'art antérieur.

### EXPOSÉ DE L'INVENTION

À cet effet, l'invention a pour objet un ensemble selon la revendication 1.

Avec cette solution, les inconvénients identifiés de l'état de la technique sont résolus, l'utilisation du profilé selon l'invention permettant de s'affranchir de l'utilisation d'inserts pour assurer la fixation d'équipements à supporter, tout en conférant une souplesse de positionnement de ces équipements. Les délais de fabrication d'un panneau support d'équipement, et coûts en résultant, sont ainsi réduits. De plus, l'intégration du tube formant caloduc au sein de ce profilé monobloc optimise les procédés d'assemblage des panneaux.

L'invention présente également de préférence une ou plusieurs des caractéristiques optionnelles suivantes, prises isolément ou en combinaison.

Le panneau peut être traversé par une servitude dont le routage est assuré le long d'un évidement du profilé.

La servitude peut être une fibre optique maintenue en position entre la peau intérieure et une rainure, formant évidement du profilé, qui est formée débouchante de préférence au niveau d'au moins l'une des première et deuxième faces, et/ou au niveau d'au moins l'une des faces latérales.

Le profilé peut s'étendre linéairement, et le tube et la gorge peuvent s'étendre à iso-distance le long de l'étendue linéaire du profilé.

A cet égard, il est noté que la gorge ne s'étend pas nécessairement sur toute la longueur du tube ou du panneau. Il pourrait être prévu plusieurs gorges séparées longitudinalement par des zones sans gorge (avec ou sans continuité du caloduc également). Cela aurait pour conséquence avantageuse une plus grande surface de contact avec la peau interne du panneau, pour un meilleur transfert de charges par exemple (dans cette zone, la peau n'est alors préférentiellement pas découpée au niveau de la gorge).

Le profilé peut comporter des éléments d'échanges de phases par capillarité, de préférence des cannelures formées en paroi interne du tube.

Le profilé peut comporter au moins une fenêtre d'insertion de l'organe d'attache d'un équipement dans la gorge.

L'invention concerne également un satellite comportant un caisson dans lequel sont embarqués des équipements électroniques, ce caisson étant délimité par au moins un ensemble selon l'un quelconque des modes de réalisation précités, pour assurer le supportage d'au moins un desdits équipements électroniques embarqués.

L'invention a également pour objet un procédé de fabrication d'un profilé tel que décrit ci-dessus, comprenant une étape d'extrusion d'un alliage au travers d'une filière pour délimiter d'un seul tenant le tube et la gorge. Comme pour le panneau, d'autres techniques de fabrication sont possibles, comme l'usinage des tubes / gorges, ou encore la fabrication additive, également dite fabrication 3D.

Enfin, quelle que soit la conception envisagée, il est noté que le tube formant caloduc est obturé de manière étanche à ses deux extrémités opposées pour contenir le fluide caloporteur du caloduc. Cette obturation est réalisée soit en rapportant des bouchons aux extrémités du tube, soit en prévoyant ces bouchons intégrés à la structure monobloc (profilé ou panneau), soit en adoptant une configuration mixant ces deux premières solutions.

### BRÈVE DESCRIPTION DES DESSINS

La figure 1, déjà décrite, est une vue en coupe d'un panneau sandwich supportant un équipement électronique et équipé d'un caloduc ;
La figure 2 est une vue schématique en perspective d'un satellite 1 comprenant un caisson délimité par des panneaux structuraux ;
La figure 3 illustre un panneau structurel depuis une vue interne au caisson de la figure 2, ce panneau comportant des profilés selon l'invention pour le support d'équipements électroniques et la dissipation de chaleur émise par de tels équipements ;
La figure 4 est une vue en coupe du panneau de la figure 3 au niveau d'un équipement électronique ;
La figure 5 est une vue de détail et en perspective d'un profilé selon l'invention.

### EXPOSÉ DÉTAILLÉ DE MODES DE RÉALISATION PARTICULIERS

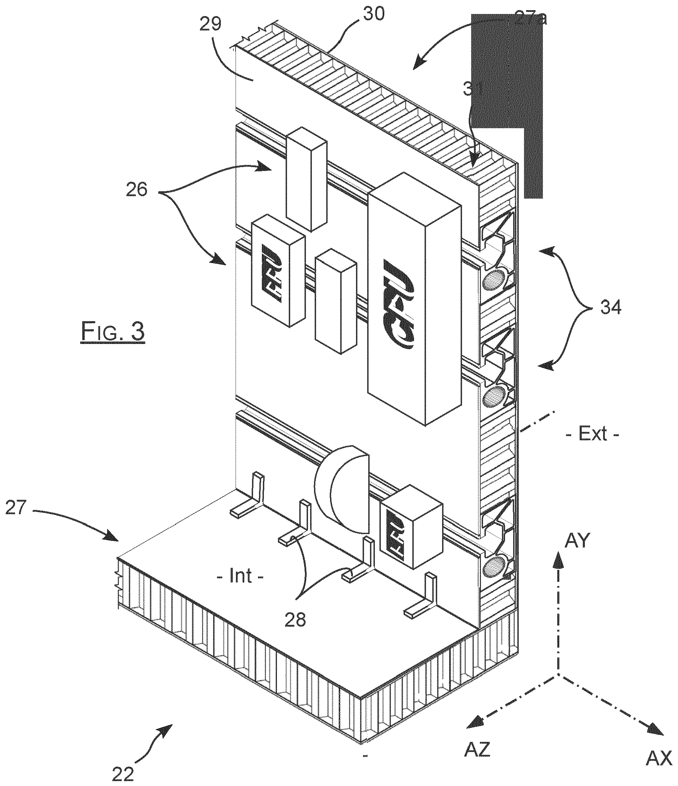

En référence aux figures 2 et 3, il est représenté un satellite 21 de type géostationnaire, à savoir un satellite mis en orbite géosynchrone et communément désigné par « satellite GEO ». Ce satellite comporte de manière conventionnelle un caisson 22 parallélépipédique qui supporte notamment un système de propulsion, non représenté, une ou plusieurs antennes de communication 23, et des bras 24 portant des panneaux solaires 25. Ces panneaux solaires permettent de subvenir notamment aux besoins énergétiques d'équipements électroniques 26 embarqués en convertissant le rayonnement solaire incident en électricité.

Parmi les équipements mentionnés, on distingue des processeurs de calcul « CPU », des unités de conditionnement puissance « PCU » qui transforment l'énergie électrique reçue des panneaux solaires en énergie utilisable, des unités de puissance et de distribution assurant des fonctions de distribution et d'avionique, des unités de gestion de puissance « PPU », des organes de pilotage de la propulsion, etc.

Ces équipements électroniques 26, désignés collectivement par charge utile, sont encapsulés dans l'enceinte du caisson 22, notée « int », qui est isolée de l'espace « ext » environnant le satellite, à savoir l'espace extra-atmosphérique en fonctionnement. Plus spécifiquement, les équipements sont supportés par tout ou partie des panneaux structuraux 27 constitutifs du caisson 22, solidarisés entre eux par une armature ou, comme représenté sur la figure 3, des équerres 28. D'autres moyens de liaison peuvent néanmoins être envisagés, sans sortir du cadre de l'invention.

Les panneaux 27 sont de nature composite en comportant chacun deux peaux définissant des plans sensiblement parallèles l'un de l'autre. Il est défini une peau dite intérieure 29 qui est accessible depuis l'enceinte du caisson, et une peau extérieure 30 accessible depuis l'extérieur de cette enceinte. Une âme 31 intercalaire est prévue entre les peaux pour assurer leur liaison et, plus globalement, une cohésion d'ensemble. Cette âme 31 est formée de manière conventionnelle de l'association d'éléments disposés régulièrement pour former un motif répétable, par exemple en "nid-d'abeilles".

Complémentairement au rôle de support des équipements électroniques 26, il s'agit que les panneaux structuraux 27 assurent à la fois un rôle de barrière au rayonnement solaire et de régulateur thermique de sorte à maintenir une température ambiante admissible au bon fonctionnement des équipements. Pour satisfaire ce besoin, les panneaux structuraux 27 sont revêtus sur la peau extérieure 30 de différentes couches, formées de kapton ou d'aluminium, de sorte à réfléchir le rayonnement solaire, et ils comportent en outre des échangeurs de chaleur de type caloduc assurant le rôle :
- de ponts thermiques entre les panneaux dit « chauds », c'est-à-dire exposés au soleil, et les panneaux dits « froids » orientés à l'ombre, le différentiel de température pouvant atteindre 200 °C ; et
- de dissipateurs de chaleur, accumulée dans le caisson, qui est émise par les équipements électroniques en fonctionnement.

L'idée à la base de l'invention est de limiter tout désagrément résultant d'une relocalisation des équipements électroniques 26 pouvant survenir post-fabrication des panneaux assurant les fonctions de supportage de ces équipements et de régulateur thermique, ou tout simplement trop tard durant la phase de conception. Un autre but est de réduire les temps de fabrication/d'usinage post-collage. Encore un autre but de l'invention réside dans l'optimisation des échanges thermiques en amenant le caloduc au plus proche de l'équipement à refroidir, ce qui est rendu possible par le couplage entre le rail et le caloduc réalisés au sein d'une même structure monobloc, c'est-à-dire réalisée d'un seul tenant. De plus, comme cela ressortira de ce qui suit, un élément différentiant de l'invention réside dans la possibilité d'allègement en utilisant la structure du caloduc pour une fonction support, limitant ainsi l'augmentation de masse générée par cette fonction support. De même, le rail participe également à la fonction structurale du panneau sandwich. A cet égard, l'invention prévoit d'équiper les panneaux structuraux 27 dédiés de profilés 34 spécifiques à la présente invention, formés chacun d'un seul tenant et qui assurent un couplage des fonctions et avantages susmentionnés tout en octroyant une relative liberté de positionnement des équipements électroniques.

Dans la suite de la description, l'agencement et la morphologie des profilés 34 seront décrits en considérant leur emplacement de destination, à savoir sur la base du panneau noté 27a de la figure 3 qui en est équipé pour supporter une pluralité d'équipements électroniques 26. Dans cet exemple, des axes AX, AY et AZ définissent respectivement des directions de longueur, hauteur et d'épaisseur du panneau 27a.

Le panneau 27a comporte de manière visible trois profilés 34 se présentant chacun sous une forme générale de barre rectiligne, et s'étendant chacun parallèlement à l'axe AX. Chaque profilé est disposé entre les deux peaux 29, 30 du panneau 27a en comprenant une face 36 dite interne disposée en contact surfacique avec la peau intérieure 29, et une face externe 37 opposée qui est disposée en contact surfacique avec la peau extérieure 30. Le panneau 27a est dépourvu d'âme en nid-d'abeilles à l'emplacement d'un profilé 34, ce profilé se substituant le long de son étendue à l'âme 31 en qualité d'interface entre les deux peaux 29, 30 dans la direction d'épaisseur, suivant AZ.

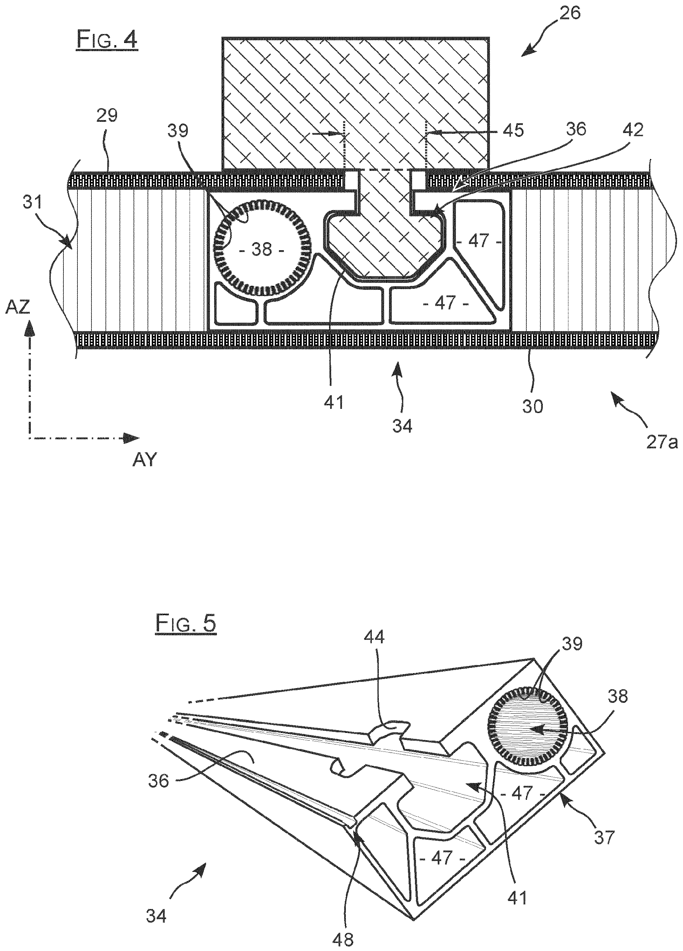

Comme visible plus en détail sur les figures 4 et 5, chaque profilé 34 délimite un tube 38. Ce tube, prévu pour former un caloduc, est rempli à cet effet d'un fluide caloporteur en étant pourvu de cannelures 39 qui s'étendent linéairement et qui dépassent radialement de sa paroi interne pour assurer un transport des phases liquide et gazeuse par capillarité. Le tube 38 est bouché de façon étanche à chacune de ses deux extrémités, de préférence par brasage. Le bouchage peut avoir lieu après le nettoyage et lors du remplissage sous pression avec le fluide caloporteur. Les bouchons font alors partie intégrante du caloduc, et un dégagement dans l'âme en nid-d'abeilles doit également être prévu. Alternativement, un remplissage a posteriori peut être envisagé, toujours en prévoyant des extrémités étanches pour maintenir le fluide caloporteur au sein du tube 38.

Le tube 38 formant caloduc peut s'étendre sur toute la longueur du panneau ou sur sensiblement toute cette longueur, voire sur une longueur réduite.

Chaque profilé 34 comporte une gorge 41 s'étendant avantageusement à iso-distance du tube 38, et qui débouche au niveau de la face interne 36 du profilé. Cette gorge 41 est prévue pour assurer une fonction de rail en étant dimensionnée de manière à pouvoir coopérer en forme avec un organe d'attache 42, par exemple de type « écrou », qui fait saillie d'un équipement électronique 26 afin d'en assurer la fixation au panneau 27a tout en autorisant un coulissement le long de celle-ci. L'organe d'attache 42 peut être solidaire de l'équipement comme représenté schématiquement sur la figure 4, ou bien par exemple un écrou logé dans la gorge et coopérant avec un élément vissé coopérant également avec l'équipement.

Avec cette solution, une modification aisée d'emplacement d'un équipement 26 en appui contre la peau intérieure 29 par coulissement le long de la gorge 41 est rendue possible. L'utilisation des profilés 34 introduit ainsi une notion d'interchangeabilité, en permettant de réaménager les équipements 26 qu'il supporte ou encore de changer aisément un équipement en cas de défaut observé.

Dans l'exemple des figures, la gorge 41 présente en section suivant AX un contour en queue d'aronde, également appelé en « T inversé », permettant d'assurer par complémentarité de forme la rétention de l'organe d'attache 42 qu'elle reçoit suivant AZ. Le blocage en position de l'organe d'attache 42 le long de la gorge 41 peut être assuré par tout dispositif ou moyen amovible connu, comme une pince ou un élément ressort, sans sortir du cadre de l'invention.

Le profilé 34 comporte en outre une ou plusieurs fenêtres 44, dont une est visible en détail sur la figure 5, qui sont définies avantageusement chacune en un point le long de la gorge 41. Une fenêtre 44 désigne ici un évidement dont l'étendue en section transversale, à savoir dans un plan normal à la direction de l'épaisseur selon AZ, est au moins égale ou supérieure à l'étendue en section transversale mesurée de la gorge 41. Comme il est compris, il s'agit de prévoir cette fenêtre 44 de taille suffisamment importante pour permettre l'insertion, depuis la face interne 36 du profilé, et le guidage de l'organe d'attache 42 dans la direction d'épaisseur AZ jusqu'à butée et engagement dans la gorge 41. Inversement, le retrait d'un équipement électronique 36 est opéré par coulissement de l'organe d'attache 42 le long de la gorge 41 jusqu'à une fenêtre 44. Avec cet arrangement, il est aisé de retirer, déplacer ou encore ajouter un équipement électronique 26

Le nombre et la disposition des fenêtres ne sont pas des facteurs limitatifs de l'invention. Il est néanmoins intéressant de noter que plusieurs fenêtres 44 facilitent l'ajout ou le retrait d'un équipement électronique 36 comparé au cas d'une fenêtre unitaire. En effet, il s'agit dans le cas unitaire de retirer tout équipement électronique 36 d'ores et déjà installé dès lors qu'il constitue un obstacle le long de la gorge 41 en empêchant l'accès à la fenêtre 44 ou à l'emplacement de destination d'un autre équipement. D'un autre côté, la multiplication des fenêtres induit une réduction de l'étendue fonctionnelle de la gorge 41, à savoir une limitation du spectre de positions possibles de fixation d'un équipement.

Les profilés 34 étant localisés au cœur du panneau 27a, il est prévu des fentes 45 formées traversantes dans la peau intérieure 29, chacune superposée suivant AY sur la gorge 41 d'un profilé correspondant. Ces fentes 45 sont dimensionnées de façon à permettre l'accès à toute fenêtre 44 depuis l'intérieur du caisson 22 et autoriser le coulissement de l'organe d'attache 42 d'un équipement dans une gorge 41. En pratique, chaque fente 45 est alignée selon AZ sur la gorge 41 d'un profilé correspondant présentant avantageusement suivant AY une étendue légèrement supérieure à celle de la gorge 41 et localement des fenêtres, de manière à limiter tout frottement.

Comme indiqué précédemment, le profilé 34 ne fait pas nécessairement toute la longueur du panneau sandwich, et plusieurs profilés 34 pourraient d'ailleurs se succéder sur la longueur du panneau. La gorge 41 et/ou la fente 45 dans la peau interne ne s'étendent pas nécessairement sur toute la longueur du profilé / panneau, et la peau ne doit pas nécessairement être découpée sur toute sa longueur, notamment pour faciliter sa manipulation après perçage / découpage.

L'invention prévoit de recourir préférentiellement au procédé d'extrusion d'un alliage au travers d'une filière, spécifiquement adapté pour la réalisation de pièces linéaires à section continue, pour fabriquer les profilés 34. Ce procédé de fabrication consiste à presser un agglomérat de billettes métalliques en fusion au travers de la filière. Cette filière, ou communément appelée matrice, présente une forme en section qui correspond au négatif de la section souhaitée du profilé 34. Des opérations d'usinage sont réalisées après extrusion et refroidissement pour former notamment les fenêtres 44 permettant l'engagement futur des organes d'attache 42 solidaires des équipements électroniques 26.

La fabrication additive peut également être utilisée en substitution à l'extrusion, plus particulièrement la fusion ou frittage laser métallique sur lit de poudre, pour la formation des profilés de manière monobloc par empilement de couches de poudre. Ce procédé est particulièrement intéressant en qu'il rend possible la formation directe des fenêtres 44, à savoir de s'affranchir d'une étape supplémentaire d'usinage dédiée de ces fenêtres 44.

Parmi les critères de sélection du matériau utilisé pour fabriquer les profilés 34, il s'agit notamment de veiller à une bonne compatibilité avec le fluide caloporteur introduit dans les tubes 38 pour former des caloducs. A titre d'exemple non limitatif, les profilés 34 peuvent être réalisés en aluminium tandis que l'ammoniac est utilisé en qualité de fluide caloporteur, cette combinaison étant particulièrement intéressante dans une application spatiale au regard des températures rencontrées.

Après fabrication du profilé 34, il s'agit à la fois de former le panneau structurel 27a, tout en veillant à remplir le tube 38 d'un fluide caloporteur avant de le sceller pour former un caloduc. Dans l'exemple des figures, les profilés 34 s'étendent sur l'intégralité de la longueur du panneau 27a selon AX. Avec cette solution, les extrémités d'un tube 38 sont directement accessibles depuis la tranche du panneau 27a, ce qui permet d'intégrer le profilé 34 entre les deux peaux 29, 30 avant scellement hermétique par obturation des extrémités, via l'utilisation de bouchons brasés, ou d'autres moyens standards de scellement de caloduc connus de l'Homme du métier. A noter qu'un scellement du tube 38 peut être réalisé en amont de l'assemblage du profilé 34 entre les deux peaux 29, 30 sans sortir du cadre de l'invention. Cette dernière particularité de conception est notamment à privilégier si le profilé considéré s'étend sur seulement une portion d'un panneau, entendu que la présence d'âme en nid-d'abeilles rend l'accès aux extrémités de tube 38 délicat une fois installé.

Le scellement du tube 38 a été décrit au-dessus comme se rapportant à l'obturation directe de ses extrémités. L'invention n'est cependant pas limitée à cette particularité de fabrication, en permettant un scellement dit indirect. Il est compris par scellement indirect l'utilisation de tout moyen permettant de garantir le maintien du fluide caloporteur au sein du tube sans requérir nécessairement une obturation de ses deux extrémités. A titre d'exemple, il est envisagé la possibilité de disposer plusieurs profilés 34 en série, au sein d'un même panneau 27 ou encore à l'interface entre deux panneaux 27 du caisson, et de raccorder fluidiquement les tubes de sorte à former conjointement un caloduc de longueur à minima équivalente à la somme des longueurs des tubes des profilés disposés bout-à-bout

L'assemblage du panneau structurel 27a de la figure 3 peut consister à coller la face externe 37 des profilés 34 sur la peau extérieure 30, avant de coller également la peau extérieure 30 sur les bandes d'âme en nid-d'abeilles 31 entre ces profilés. Parallèlement, la peau intérieure 29 est découpée pour former les fentes 45, puis collée ensuite sur les profilés et les bandes d'âme 31 les entourant en veillant à ce que les fentes 45 se superposent aux gorges 41. Ce procédé de fabrication ne fait pas intervenir de fixation par visserie, ce qui limite sensiblement le nombre d'étapes de fabrication. Néanmoins, un procédé de collage en une seule et unique étape est préférée.

Les profilés 34 selon l'invention octroient des performances thermiques améliorées, en plus de limiter les temps de fabrication des panneaux qu'ils équipent et d'apporter un degré de liberté en positionnement des équipements électroniques 26. En effet, il convient de souligner que la nature monobloc du profilé 34, couplée à l'engagement direct dans la gorge 41 de l'organe d'attache 42, induit un contact direct et une meilleure efficacité en matière d'échange thermique.

Concrètement, la chaleur émise par l'équipement 26 se diffuse directement vers le caloduc, lequel est issu de l'association du tube 38 et du fluide caloporteur confiné en son sein, en passant par l'organe d'attache 42 en contact avec le profilé 34. Autrement dit, l'invention permet de limiter les interfaces et la distance entre l'équipement électronique 26 émetteur de chaleur et le caloduc, amenant la source froide au plus proche de la source chaude et augmentant ainsi l'efficacité du caloduc.

Aussi, l'invention prévoit de former des évidements dans les profilés 34 de sorte à limiter la masse globale des panneaux 27, tout en veillant à conserver une raideur admissible. De tels évidements, peuvent prendre la forme de chambres 47 traversantes qui longent le tube 38 et la gorge 41. Ces évidements peuvent avantageusement être utilisés pour assurer une fonction supplémentaire de routage de « servitudes » dans un panneau 27. Les servitudes peuvent désigner des câbles électriques sous forme de harnais, des canalisations parcourues par des fluides, ou tout moyens filaires permettant d'assurer le transport d'énergie et d'information, par exemple entre deux équipements 26.

Dans l'exemple de la figure 5, une rainure 48 est formée au niveau de la face interne 36 et dans laquelle est disposée une fibre optique, non représentée, qui est maintenue en position entre le profilé 34 et la peau intérieure 29.

L'invention a été expliquée sur la base du panneau 27a de la figure 3 annexée, qui comporte trois profilés 34 qui s'étendent linéairement en étant orientés parallèlement à l'axe AX et sont décalés les uns des autres le long de l'axe AY. Cet arrangement est particulièrement optimisé dans le cas où le cahier des charges de fabrication renseigne de l'intégration future de plusieurs lots d'équipements en colonnes suivant AY et installés en cascade selon AX.

Comme il est compris, cette souplesse de conception permet d'entreprendre la fabrication du panneau sans requérir des coordonnées exactes, dans l'exemple illustré selon AX, et conduit ainsi à limiter les délais de production. Cet aspect suggère la possibilité de produire des panneaux 27 dits standards, avec des positionnements de profilé préétablis.

Concrètement, l'invention n'est pas limitée à l'arrangement particulier de la figure 3, notamment au regard de la désignation des directions d'axes ou encore de la condition de parallélisme des profilés 34. Il est permis différentes orientations de profilés 34. De la même manière, l'invention n'est pas limitée à un nombre donné de profilés 34 équipant un panneau 27, ni à ce que ces profilés s'étendent de façon rectiligne. En pratique, les profilés peuvent présenter une morphologie à courbure sans sortir du cadre de l'invention.

Les profilés 36 ont été décrits comme des structures prévues pour être intégrées en cœur de panneau 27, entre les deux peaux 29, 30. Cependant, il peut être envisagé que les profilés 34 soient rapportés directement sur la peau intérieure 29 pour réduire encore davantage les temps d'assemblage, même si cette configuration octroie une efficacité thermique inférieure. En pareil cas, un contact thermique direct est observé entre les équipements électroniques et la face interne 36 du profilé qu'il supporte. Egalement, les panneaux peuvent eux-mêmes être réalisés d'une seule pièce et intégrer les éléments / fonctions attachés aux profilés décrits ci-dessus.

Il est à noter qu'un profilé peut comporter plusieurs tubes 38 formant caloducs en réponse notamment à un besoin en dissipation thermique plus élevé, et/ou plusieurs gorges 41 pour assurer un meilleur maintien et une capacité plus importante de supportage des équipements électroniques 26. En ce qui concerne les tubes 38, l'existence des cannelures 39 dépassant de leur paroi interne n'apparait pas essentielle, en particulier s'il s'agit de former des caloducs dits actifs, en opposition aux caloducs dits passifs, à savoir dans le cas où le fluide caloporteur est pompé au sein du tube moyennant une pompe et une électronique de commande active. Il est néanmoins noté que dans le cas d'un fonctionnement passif par capillarité, d'autres éléments réputés appropriés peuvent être mis en œuvre à la place des cannelures 39, de manière à permettre l'échange des phases au sein du caloduc.

Enfin, l'invention a été décrite comme se rapportant à la fabrication de panneaux structuraux comportant des profilés 34 permettant d'assurer à la fois une fonction de régulation thermique par caloduc et une fonction de support d'équipements électronique dans le domaine spatial. Cependant, l'ensemble selon l'invention trouve également son application dans d'autres domaines pour la fabrication de panneaux, de nature composite ou non, prévus pour supporter tout type d'équipements émetteurs de chaleur, comme dans les domaines de l'avionique ou l'électronique, afin d'assurer les fonctions susmentionnées.

## Revendications

1. Ensemble comportant un organe d'attache (42) et un panneau (27) pour supporter des équipements, le panneau comprenant au moins une partie monobloc réalisée par un profilé (34), ledit profilé comportant:
- un tube (38) adapté pour former un caloduc par introduction et confinement en son sein d'un fluide caloporteur, et
- une gorge (41) prévue pour former le long de son étendue un rail de fixation d'au moins un équipement (26) destiné à être supporté par le panneau (27), cette gorge (41) étant conformée pour coopérer par complémentarité de forme avec l' organe d'attache (42) configuré pour être solidaire dudit au moins un équipement (26),
ledit panneau comportant deux peaux (29, 30), respectivement intérieure (29) et extérieure (30), et dans lequel le profilé (34) est installé entre ces deux peaux (29, 30) en étant délimité par une première face (36) en appui contre la peau intérieure (29) et une deuxième face (37) en appui avec la peau extérieure (30),
la gorge (41) du profilé étant formée débouchante au niveau de la première face (36) et, complémentairement, une fente (45) étant formée traversante dans la peau intérieure (29) en étant superposée sur la gorge (41) pour permettre le supportage et le déplacement dudit au moins un
équipement (26) en appui sur la peau intérieure (29) par engagement et coulissement de l'organe d'attache (42) correspondant dans la gorge (41), au travers de la fente (45).

2. Ensemble selon la revendication 1, traversé par une servitude dont le routage est assuré le long d'un évidement du profilé (34).

3. Ensemble selon la revendication 2, dans lequel la servitude est une fibre optique maintenue en position entre la peau intérieure (29) et une rainure (48), formant évidement du profilé, qui est formée débouchante de préférence au niveau d'au moins l'une des première et deuxième faces (36, 37), et/ou au niveau d'au moins l'une des faces latérales.

4. Ensemble selon l'une des revendications précédentes, le profilé (34) s'étendant linéairement et dans lequel le tube (38) et la gorge (41) s'étendent à iso-distance le long de l'étendue linéaire du profilé.

5. Ensemble selon l'une des revendications précédentes, le profilé (34) comportant des éléments d'échanges de phases par capillarité, de préférence des cannelures (39) formées en paroi interne du tube (38).

6. Ensemble selon l'une des revendications précédentes, le profilé (34) comportant au moins une fenêtre (44) d'insertion de l'organe d'attache (42) d'un équipement (26) dans la gorge (41).

7. Satellite (21) comportant un caisson (22) dans lequel sont embarqués des équipements électroniques (26), ce caisson (22) étant délimité par au moins un ensemble selon l'une quelconque des revendications 1 à 6 pour assurer le supportage d'au moins un desdits équipements électroniques (26) embarqués.

## Patentansprüche

1. Baugruppe, die ein Befestigungselement (42) und eine Platte (27) umfasst, um Geräte zu tragen, wobei die Platte mindestens ein einteiliges Teil umfasst, das aus einem Profilelement (34) hergestellt wird, wobei das Profilelement Folgendes umfasst:
- ein Rohr (38), das dazu ausgelegt ist, durch Einführen und Einschließen eines Wärmeträgerfluids in seinem Inneren ein Wärmerohr zu bilden, und
- eine Nut (41), die dazu vorgesehen ist, entlang ihrer Erstreckung eine Befestigungsschiene für mindestens ein Gerät (26) zu bilden, das dazu bestimmt ist, von der Platte (27) getragen zu werden, wobei die Nut (41) dazu ausgebildet ist, komplementär mit einem Befestigungselement (42) zusammenzuwirken, das so konfiguriert ist, dass es fest mit dem mindestens einen Gerät (26) verbunden ist,
wobei die Platte zwei Häute (29, 30) umfasst, jeweils eine Innenhaut (29) und eine Außenhaut (30), und wobei das Profilelement (34) zwischen den beiden Häuten (29, 30) angebracht ist und durch eine erste Fläche (36), die an der Innenhaut (29) anliegt, und eine zweite Fläche (37), die an der Außenhaut (30) anliegt, begrenzt ist,
wobei die Nut (41) des Profilelements so ausgebildet ist, dass sie an der ersten Fläche (36) offen ist, und zusätzlich ein Schlitz (45) durchgehend in der Innenhaut (29) ausgebildet ist, indem er der Nut (41) überlagert wird, um das Tragen und Bewegen des mindestens einen an der Innenhaut (29) anliegenden Geräts (26) durch das Eingreifen und Verschieben des entsprechenden Befestigungselements (42) in der Nut (41) durch den Schlitz (45) hindurch zu ermöglichen.

2. Baugruppe nach Anspruch 1, die von einer Hilfe durchzogen, deren Führung entlang einer Aussparung im Profilelement (34) gewährleistet ist.

3. Baugruppe nach Anspruch 2, wobei die Hilfe ein Lichtwellenleiter ist, der in Position zwischen der Innenhaut (29) und einem Kanal (48) gehalten wird, der eine Aussparung des Profilelements bildet, die so ausgebildet ist, dass sie vorzugsweise an mindestens einer von der ersten und der zweiten Fläche (36, 37) und/oder an mindestens einer der Seitenflächen offen ist.

4. Baugruppe nach einem der vorhergehenden Ansprüche, wobei sich das Profilelement (34) linear erstreckt und wobei sich das Rohr (38) und die Nut (41) in Isodistanz entlang der linearen Erstreckung des Profilelements erstrecken.

5. Baugruppe nach einem der vorhergehenden Ansprüche, wobei das Profilelement (34) Elemente des Phasenaustauschs durch Kapillarität, vorzugsweise Riffelungen (39), umfasst, die in der Innenwand des Rohrs (38) ausgebildet sind.

6. Baugruppe nach einem der vorhergehenden Ansprüche, wobei das Profilelement (34) mindestens ein Fenster (44) zum Einführen des Befestigungselements (42) für ein Gerät (26) in die Nut (41) umfasst.

7. Satellit (21), der ein Gehäuse (22) umfasst, in dem elektronische Geräte (26) integriert sind, wobei das Gehäuse (22) durch mindestens eine Baugruppe nach einem der Ansprüche 1 bis 6 begrenzt ist, um das Tragen von mindestens einem der integrierten elektronischen Geräte (26) zu gewährleisten.

## Claims

1. An assembly comprising an attachment member (42) and a panel (27) for supporting equipment, the panel comprising at least one single-piece portion made by a profile section (34), said profile section including:
- a tube (38) suitable for forming a heat pipe by introducing and confining a heat-transfer fluid inside of same, and
- a groove (41) provided to form a rail along its length for securing at least one piece of equipment (26) intended to be supported by the panel (27), this groove (41) being shaped to form-fittingly engage with said attachment member (42) configured to be rigidly connected to said at least one piece of equipment (26),
said panel including two skins (29, 30), respectively internal (29) and external (30) skins, and wherein the profile section (34) is installed between these two skins (29, 30) being delimited by a first face (36) resting against the internal skin (29) and a second face (37) resting against the external skin (30),
the groove (41) of the profile section being formed to open at the first face (36) and, additionally, a slot (45) being formed continuous in the internal skin (29) while being superimposed on the groove (41) to allow the support and movement of said at least one equipment (26) resting on the internal skin (29) by engagement and sliding of the corresponding attachment member (42) in the groove (41), through the slot (45).

2. Assembly (27) according to claim 1, traversed by an easement whose routing is ensured along a recess in the profile section (34).

3. Assembly (27) according to claim 2, wherein the easement is an optical fibre held in position between the internal skin (29) and a channel (48), forming a recess of the profile section, which is formed to open preferably at least at one of the first and second faces (36, 37), and/or at least at one of the side faces.

4. Assembly according to one of the preceding claims, the profile section (34) extending linearly and wherein the tube (38) and the groove (41) extend at iso-distance along the linear length of the profile section.

5. Assembly according to one of the preceding claims, the profile section (34) including capillarity phase exchange elements, preferably splines (39) formed in the internal wall of the tube (38).

6. Assembly according to one of the preceding claims, the profile section (34) including at least one window (44) for inserting the member (42) for attaching an equipment (26) into the groove (41).

7. A satellite (21) including a box (22) wherein electronic equipment (26) is boarded, this box (22) being delimited by at least one assembly according to any one of claims 1 to 6 to ensure the support of at least one of said on-board electronic equipment (26).
